# EUROPÄISCHE PATENTANMELDUNG

(11) **EP 1 087 233 A1**
(43) Veröffentlichungstag der Anmeldung: **28.03.2001**
(21) Anmeldenummer: 99118825.1
(22) Anmeldetag: 23.09.1999
(51) Int. Cl.: G01R 31/3185

(54) **Verfahren und Anordnung zum datenschützenden Selbsttest für Microcontroller**

(71) Anmelder: Infineon Technologies AG, 81669 München (DE)
(72) Erfinder: Richter, Michael, 85521 Ottobrunn (DE); Otterstedt, Jan, Dr., 81673 München (DE)
(74) Vertreter: Hermann, Uwe, Dipl.-Ing.

(57) **Zusammenfassung**

Die Erfindung betrifft ein Verfahren zum datenschützenden Selbsttest für Microcontroller, bei dem alle Schaltungselemente innerhalb des Microcontrollers getestet werden können, wobei der Ablauf des Selbsttests über die externen Pins nicht verändert werden kann, keine Zwischenergebnisse über die Pins nach extern gelangen. Die Erfindung betrifft weiterhin eine Anordnung in Form einer integrierten Schaltung, mit der das Verfahren realisiert werden kann und entsprechend ausgestattete Microcontroller.

## Beschreibung

Die Erfindung betrifft ein Verfahren sowie eine Anordnung, in Form einer integrierten Schaltung zum datenschützenden Selbsttest für Microcontroller.

Bei der Herstellung integrierter Schaltungen (IC) ist der Fertigungstest ein die Qualität entscheidend mitbestimmender Aspekt. Im Normalfall werden dazu die integrierten Schaltungen auf einem Testsystem mit einer Vielzahl von Testmustern an den Eingangspins der ICs stimuliert und die Testantworten an den Ausgangspins der ICs gemessen und mit den im Testsystem gespeicherten Sollwerten verglichen.

Ein Problem ergibt sich hieraus für eine bestimmte Klasse von ICs, der sogenannten Sicherheits-ICs, wie sie z.B. für die Datenverschlüsselung oder zur hardwaremäßigen Absicherung von Übertragungsprotokollen eingesetzt werden. Bei diesen ICs unterliegen Aufbau und Funktion bestimmten Sicherheitsanforderungen, die - vereinfacht ausgedrückt - bedingen, daß für Nicht-Berechtigte über die Pins des IC kein Zugang zu den internen Schaltungselementen des IC möglich sein darf. Aus diesem Grund kann hier die geschilderte Testmethodik nicht angewandt werden, da durch die Kenntnis und Speicherung von Eingangsdaten sowie der zugehörigen Soll-Ausgangsdaten in z.B. einem Testsystem oder einem PC Rückschlüsse auf den Aufbau und die Funktion des IC möglich wären. Dennoch muß auch für diese Klasse von ICs ein adäquater Fertigungstest durchgeführt werden.

Zur Lösung dieses Problems sind Selbsttests (BIST, Built-In Self-Test) entwickelt worden. Ein Selbsttest erfordert meist nur die Angabe eines Startsignals; nach einer vorgegebenen Zeit kann dann die im IC aufbereitete Testantwort ausgelesen werden. Da diese Testantwort aus der Komprimierung einer großen Zahl von Einzel-Testergebnissen zu einem einzigen Datensatz besteht, kann in der Regel aus dieser Testantwort kein Rückschluß auf Aufbau und Funktion des IC gezogen werden.

Zur Realisierung eines Selbsttests kann man für Microcontroller zwei verschiedene Ansätze unterscheiden:
- einen Selbsttest, der aus der Ausführung eines im Microcontroller selbst gespeicherten Testprogramms besteht;
- einen Selbsttest, wie er z.B. in IEEE-Standard 1149.1 "Standard Test Access Port and Boundary-Scan Architecture" unter dem Begriff "RUNBIST" als optionale Funktion beschrieben wird.

Der prinzipielle Vorteil eines Selbsttests mittels eines im Microcontroller selbst gespeicherten Testprogramms besteht darin, daß das Testprogramm vor der Durchführung des eigentlichen Tests auf vielfältige Weise die Berechtigung zur Durchführung des Selbsttests prüfen kann. Dies kann u.a. durch externe Eingabe eines Passwortes geschehen, das mit einem im Microcontroller gespeicherten Sollwert verglichen wird, wobei der Selbsttest nur bei positivem Ergebnis der Prüfung gestartet wird.

Jedoch weist der Ansatz über ein im Microcontroller selbst gespeichertes Testprogramm in der Regel erhebliche Nachteile auf. Ein Nachteil ist, daß durch Software nicht alle Schaltungselemente innerhalb des Microcontrollers stimuliert bzw. beobachtet werden können. Dies hat zur Folge, daß die Qualität des Fertigungstests nicht ausreichend hoch ist. Hinzu kommt, daß der erforderliche zusätzlich integrierte Speicher für die Testbefehle die Chipfläche erhöht. Ein weiterer Nachteil ist, daß die Ausführung eines Testprogramms - verglichen mit einem üblichen Test mittels Testautomat - in der Regel um mindestens den Faktor 10 langsamer ist.

Der Ansatz über den Selbsttest mittels des z.B. im IEEE-Standard 1149.1 beschriebenen Boundary Scan löst in der Regel das Problem der Zugänglichkeit interner Schaltungsknoten, da hier alle Ein- und Ausgänge des IC bei der Generierung von Testmustern und Testantworten beteiligt sind. Jedoch erfüllt dieser Selbsttest nur geringe Sicherheitsanforderungen, da die Testmustergenerierung intern abläuft, die Testantworten aber seriell über den Boundary Scan ausgeschoben werden und die Ablaufsteuerung des Selbsttests durch den standardisierten TAP-Controller von außen jederzeit verändert werden kann. So könnte ein "Angreifer" diesen Selbsttest dazu mißbrauchen, um an Geheimnisse im Chip zu gelangen. Dazu würde er den Selbsttest beliebig oft wiederholen, aber die Dauer des Selbsttests durch die Zahl der Taktzyklen, die das System im Zustand "Run-Test/Idle" verharrt, ständig und systematisch variieren und aus den dann jeweils ausgelesenen Ergebnissen Rückschlüsse auf den Chipinhalt ziehen. Die dazu nötigen Steuersignale sind entsprechend dem IEEE-Standard extern frei zugänglich, es gibt keinerlei Schutz gegen derartiges "Ausspionieren".

Aufgabe der Erfindung ist es vor diesem Hintergrund, ein Verfahren und eine Anordnung (in Form einer integrierten Schaltung) anzugeben, die einen vollständigen und schnellen, gegen Angriffe geschützten Selbsttest ermöglichen.

Hinsichtlich des Selbsttestverfahrens ist die erfindungsgemäß zur Lösung der Aufgabe dienende Merkmalskombination im Anspruch 1 definiert. Die entsprechende Merkmalskombination der Anordnung nennt der Anspruch 14. Gegenstand der Erfindung ist weiterhin ein Microcontroller gemäß Anspruch 33.

Bevorzugte Ausführungsformen sind in den Unteransprüchen definiert; vorteilhafte Ausgestaltungen der Erfindung ergeben sich zudem aus der folgenden Beschreibung eines Ausführungsbeispiels.

Der Microcontroller besitzt danach einen Boundary Scan, vorzugsweise entsprechend IEEE-Standard 1149.1. Jedoch sind nur die im IEEE-Standard aufgeführten obligatorischen Testbefehle implementiert, so wie sie nach der Intention des Boundary Scan für den Fertigungstest einer Leiterplatte (und nicht des IC) vorgesehen sind.

Der BIST nutzt nun die Register des Boundary Scan, um Chip-intern pseudo-zufällige Testmuster zu generieren und Testantworten zu komprimieren. Da das Boundary Scan-Register die gesamte Logik des Bausteins bis auf die Ein- und Ausgabezellen umschließt, ist es optimal geeignet, eine maximale Zahl interner Schaltungsknoten über den Selbsttest zu erreichen, was wiederum Voraussetzung für eine möglichst hohe Fehlerüberdekkung und damit Qualität des Fertigungstests ist.

Entsprechend der Erfindung wird dieser BIST jedoch nicht direkt von außen (z.B. über den Befehl "RUNBIST", wie er im IEEE-Standard angegeben ist) gestartet, sondern über den Microcontroller. Der Microcontroller prüft vorab die Berechtigung zur Durchführung des Selbsttests. Während des Selbsttests überwacht der Microcontroller die korrekte Ausführung des Selbsttests, auch indem er keine Unterbrechung des Selbsttests zuläßt. Dazu gehört auch, daß während des BIST über den Boundary Scan keine Testbefehle (entsprechend dem IEEE-Standard) akzeptiert werden, also der im IEEE-Standard angegebene TAP-Controller damit logisch von den Boundary Scan-Zellen abgekoppelt wird. Am Testende kann die komprimierte Testantwort entweder über den Microcontroller ausgegeben oder mit einer in einem Festwertspeicher des Microcontrollers gespeicherten Sollantwort verglichen werden.

Die Erfindung ermöglicht also prinzipiell eine vorteilswahrende Verschmelzung beider bekannten Ansätze und der damit verbundenen logischen Abfolge. Zunächst prüft das im Microcontroller integrierte Testprogramm die Berechtigung für die Ausführung des Selbsttests. Ist diese Bedingung erfüllt, startet das Testprogramm den Selbsttest, indem die Steuersignale des TAP-Controllers logisch vom Boundary Scan-Register abgekoppelt werden, die Testlogik in einen definierten Anfangszustand gesetzt und der Selbsttest gestartet wird. Am Testende liest das Testprogramm die im Boundary Scan-Register gespeicherte Testantwort in einen internen Speicher und löscht anschließend die Testantwort im Boundary Scan-Register. Danach wird der TAP-Controller wieder freigegeben. Die im Microcontroller gespeicherte Testantwort kann nun je nach Implementierung mit einer im Testprogramm abgelegten Sollantwort verglichen oder nach extern ausgegeben werden.

Durch diesen Ablauf wird sichergestellt, daß nur Berechtigte den Selbsttest ausführen können, daß der Ablauf des Selbsttests über die externen Pins nicht verändert werden kann und daß keine Zwischenergebnisse über die Pins nach extern gelangen. Dennoch ist ein schneller vollständiger Selbsttest unter Einbeziehung aller Elemente des Microprozessors ermöglicht.

Im folgenden wird beispielhaft eine bevorzugte Ausführungsform der Erfindung anhand der beigefügten Zeichnungen näher erläutert.

Darin zeigen:
- Figur 1: ein Blockdiagramm eines Microcontrollers;
- Figur 2: ein Ablaufdiagramm für eine bevorzugte Ausführungsform der Erfindung;
- Figur 3: eine Schaltung für eine Eingangs-Boundary Scan-Zelle zur Erzeugung von Testmustern;
- Figur 4: eine Schaltung für einen Ausgangs-Boundary Scan-Zelle zur Aufnahme von Testantworten und
- Figur 5: den prinzipiellen Signalfluß bei der Ausführungsform gemäß Fig. 2 bis 4.

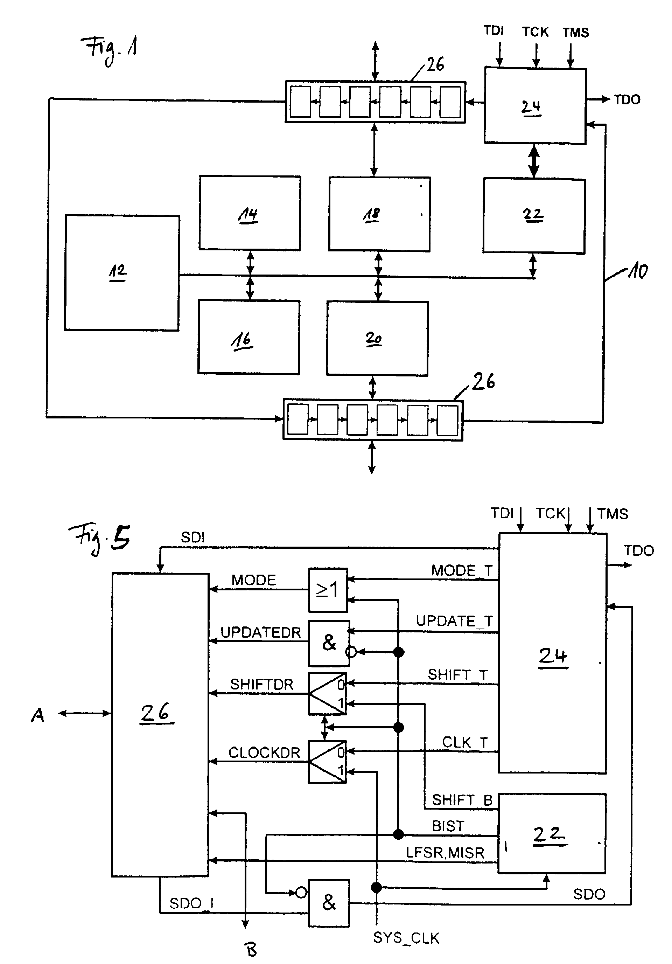

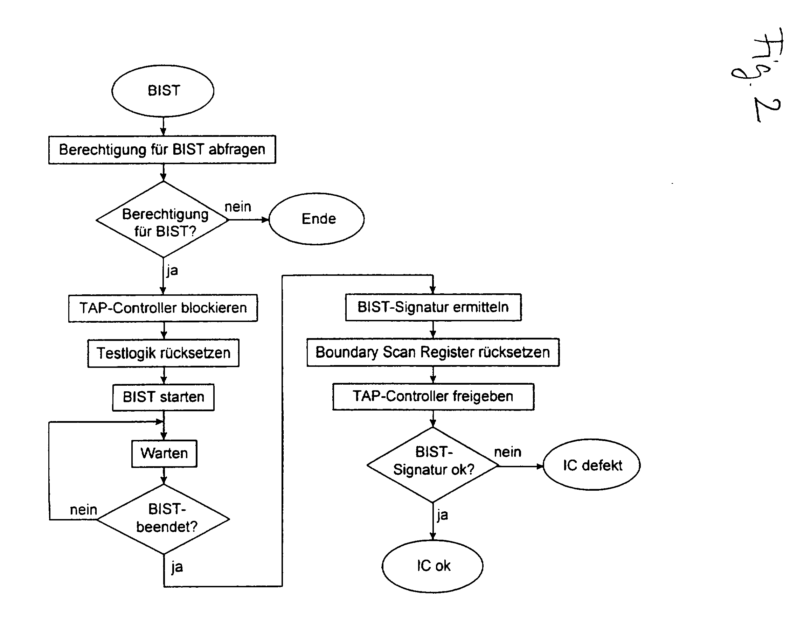

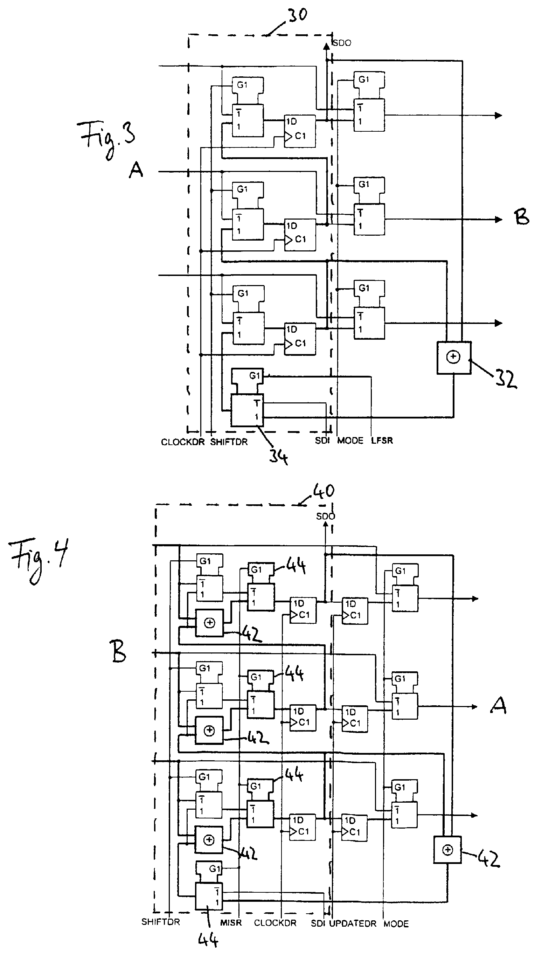

Fig. 1 zeigt ein Blockdiagramm eines Microcontrollers 10 mit Boundary Scan, bestehend aus CPU 12, RAM 14, ROM 16, Ein-/ Ausgabeeinheit 18, Peripherieeinheiten (z.B. Timer, Co-Prozessoren) 20, BIST-Controller 22, Boundary Scan TAP-Controller 24, sowie Boundary Scan-Zellen 26. Diese kommunizieren mit den Pads (A in Fig. 3 und 4) und dem Schaltungskern (B in Fig. 3 und 4).

Fig. 2 zeigt ein Beispiel für den logischen Ablauf des Selbsttests. Die Aufforderung an den Microcontroller 10, den Selbsttest zu starten, kann auf verschiedene Weise erfolgen: durch ein externes Signal, durch einen Befehl, der an den Microcontroller übergeben wird, durch einen internen Timer etc. Zunächst prüft das im Microcontroller 10 integrierte Testprogramm die Berechtigung für die Ausführung des Selbsttests. Diese Prüfung kann je nach Ausprägung erfolgen durch Vergleich eines Istwertes mit einem im Microcontroller gespeicherten Sollwert, durch Prüfung eines Passwortes, durch Authentifikation der externen, beauftragenden Instanz (z.B. Hostrechner, Testsystem) durch den Microcontroller 10 oder in anderer geeigneter Weise.

Ist diese Prüfung erfolgreich, wird der TAP-Controller blokkiert, die Testlogik rückgesetzt und das Testprogramm startet den Selbsttest. Hierzu genügt es, wenn der Microcontroller 10 im BIST-Controller 22 ein entsprechendes Startbit setzt. Alternativ ist auch ein Assemblerbefehl "RUNBIST" denkbar, der nur bei erfolgreicher Prüfung ausführbar ist und implizit den BIST-Controller 22 startet. Bei nicht erfolgreicher Prüfung der Erlaubnis wird das Testprogramm verlassen und z.B. ein Reset ausgelöst.

Nach dem Start des Selbsttests wartet der Microcontroller 10, bis die Hardware des BIST-Controllers 22 das Testende an den Microcontroller 10 signalisiert. Diese Signalisierung kann auf vielfältige Weise durch Abfrage eines Statusbits im BIST-Controller 22, durch einen vom BIST-Controller 22 ausgelösten Interrupt, oder durch einen integrierten Timer erfolgen. Anschließend wird die BIST-Signatur durch Auslesen des Boundary Scan-Registers in das interne RAM 14 ermittelt. Danach wird das Boundary Scan-Register rückgesetzt und anschließend der TAP-Controller 24 wieder freigegeben. Durch das Rücksetzen des Boundary Scan-Registers wird verhindert, daß die Signatur (oder Teile davon) über den TAP-Controller 24 auslesbar sind.

Die Prüfung der Signatur kann entweder im Microcontroller 10 selbst oder extern erfolgen.

Fig. 3 und 4 zeigen beispielhafte Implementierungen von Boundary Scan-Registerzellen 26, die zur Generierung von Testmustern (Fig. 3) bzw. der Auswertung der Testantworten (Fig. 4) verwendet werden.

Fig. 3 zeigt ein 3-Bit LFSR 30 (Linear Feedback Shift Register) als Teil einer Schaltung für eine erfindungsgemäße BS-Zelle. Die entsprechend der Erfindung zusätzlich eingefügten Schaltelemente XOR 32 und Multiplexer 34 sind fett gezeichnet. Mittels Signal LFSR werden während des Selbsttests das Boundary Scan-Schieberegister aufgetrennt und über das LFSR Testmuster generiert. Die Signale SHIFTDR und MODE sind dabei auf '1'-Pegel gesetzt. Mit jedem Takt des Signals CLOCKDR wird ein neues Testmuster erzeugt.

Fig. 4 zeigt als Beispiel einer Schaltung für die Aufnahme der Testantworten ein 3-Bit MISR (Multiple Input Signature Register) 40. Die entsprechend der Erfindung zusätzlich eingefügten Schaltelemente XOR 42 und Multiplexer sind fett gezeichnet. Mittels Signal LFSR wird während des Selbsttests das Boundary Scan-Schieberegister aufgetrennt. Das MISR 40 summiert die Testantworten aus dem Schaltungskern auf. Die Signale SHIFTDR und MODE sind dabei auf '1'-Pegel gesetzt.

Mit jedem Takt des Signals CLOCKDR wird eine weitere Testantwort aufsummiert. Das Signal UPDATEDR wird vom BIST-Controller gesperrt, damit gelangen während des Selbsttests keine Ergebnisse an die externen Pins.

Fig. 5 veranschaulicht den Signalfluß zwischen dem BIST-Controller 22, dem TAP-Controller 24, hinsichtlich der aus beiden abgeleiteten Steuersignale. Der standardgemäße TAP-Controller 24 wird durch die externen Signale TCK (Test Clock), TMS (Test Mode Select), TDI (Test Data Input) und TDO (Test Data Output) gesteuert. Die vom TAP-Controller 24 generierten internen Steuersignale (MODE_T, UPDATE_T, SHIFT_T, CLK_T) werden während des laufenden Selbsttests durch Signale aus dem BIST-Controller 22 (SHIFT_B, BIST) blockiert:
- Der BIST-Controller 22 setzt während des Selbsttests die Signale BIST, LFSR, MISR und SHIFT_B. Er selbst wird dabei über SYS_CLK, dem Systemtakt des Microcontrollers 10, getaktet.
- Signal MODE wird durch eine ODER-Verknüpfung auf '1'-Pegel gehalten, womit die in Fig. 3 und 4 vom Signal MODE angesteuerten Multiplexer 34, 44 so eingestellt werden, daß über die Eingangspins (A) keine externen Daten in den Schaltungskern (B) gelangen und so den Ablauf des Selbsttests manipulieren könnten (Fig. 3) bzw. keine (Zwischen-) Testantworten an die Ausgangspins (A) gelangen können.
- Signal UPDATEDR wird durch die UND-Verknüpfung mit negiertem Eingang auf '0'-Pegel gehalten, damit während des Selbsttests keine (Zwischen-) Testantworten an die Ausgangspins (A) gelangen können.
- Signal SHIFTDR wird für die LFSR 30 zur Bildung der Schiebefunktion auf '1'-Pegel gesetzt; für die MISR 40 ist sein Pegel ohne Bedeutung.
- Signal CLOCKDR, mit dem LFSR 30 und MISR 40 getaktet werden, wird auf SYS-CLK, dem Systemtakt des Microcontrollers 10, umgestellt.
- Signal SDO wird durch die UND-Verknüpfung mit negiertem Eingang auf '0'-Pegel gehalten, damit aus dem Boundary Scan-Schieberegister keine (Zwischen-) Testantworten an den externen Ausgang TDO des TAP-Controllers 24 gelangen können.

## Patentansprüche

1. Verfahren zum datenschützenden Selbsttest für Microcontroller, bei dem alle Schaltungselemente innerhalb des Microcontrollers getestet werden können,
**dadurch gekennzeichnet** ,
daß der Ablauf des Selbsttests über die externen Pins nicht verändert werden kann und daß keine Zwischenergebnisse nach extern gelangen.

2. Verfahren nach Anspruch 1,
**dadurch gekennzeichnet**,
daß der Microcontroller einen Boundary Scan, insbesondere entsprechend IEEE-Standard 1149.1 besitzt, wobei jedoch nur die obligatorischen Testbefehle, die nach der Intention des Boundary Scan für den Fertigungstest einer Leiterplatte vorgesehen sind, implementiert sind und daß das Testprogramm im Microcontroller selbst gespeichert ist.

3. Verfahren Anspruch 1 oder 2,
**dadurch gekennzeichnet**,
daß das im Microcontroller gespeicherte Testprogramm ein Selbsttest (BIST, Built-In Self Test) ist.

4. Verfahren nach Anspruch 3,
**dadurch gekennzeichnet**,
daß der BIST die Register des Boundary Scan nützt, um Chip-intern Testmuster zu generieren.

5. Verfahren nach Anspruch 3 oder 4,
**dadurch gekennzeichnet**,
daß der BIST die Register des Boundary Scan nützt, um Chip-intern die Testantworten zu komprimieren.

6. Verfahren nach einem der Ansprüche 3 bis 5,
**dadurch gekennzeichnet**,
daß der BIST nicht direkt von extern gestartet wird, sondern über den Microcontroller.

7. Verfahren nach einem der oder mehreren der vorhergehenden Ansprüche,
**dadurch gekennzeichnet**,
daß vor dem Start des Selbsttests die Berechtigung zur Durchführung des Selbsttests durch den Microcontroller überprüft und bei fehlender Berechtigung der Selbsttest nicht gestartet wird.

8. Verfahren einem oder mehreren der vorhergehenden Ansprüche,
**dadurch gekennzeichnet**,
daß die korrekte Ausführung des Selbsttests durch den Microcontroller überwacht und insbesondere keine Unterbrechung des Selbsttests zugelassen wird.

9. Verfahren nach einem der Ansprüche 3 bis 8,
**dadurch gekennzeichnet**,
daß durch den Microcontroller überwacht wird, daß während das BIST über den Boundary Scan keine Testbefehle entsprechend des verwendeten Standards akzeptiert werden, und insbesondere, daß der TAP-Controller logisch von den Boundary Scan-Zellen abgekoppelt wird.

10. Verfahren nach einem der Ansprüche 3 bis 9,
**dadurch gekennzeichnet**,
daß, nachdem der TAP-Controller logisch von den Boundary Scan-Zellen abgekoppelt wurde, die Testlogik in einen definierten Anfangszustand gesetzt wird.

11. Verfahren nach einem der Ansprüche 2 bis 10,
**dadurch gekennzeichnet**,
daß die im Boundary Scan-Register gespeicherte Testantwort in einen internen Speicher gelesen und anschließend die im Boundary Scan-Register gespeicherte Testantwort gelöscht wird.

12. Verfahren nach einem oder mehreren der vorhergehenden Ansprüche,
**dadurch gekennzeichnet**,
daß am Testende die komprimierte Testantwort über den Microcontroller ausgegeben wird.

13. Verfahren nach einem oder mehreren der vorhergehenden Ansprüche,
**dadurch gekennzeichnet**,
daß am Testende die komprimierte Testantwort mit einer im Festwertspeicher des Microcontrollers gespeicherten Sollantwort verglichen wird.

14. Anordnung in Form einer integrierten Schaltung zum datenschützenden Selbsttest für Microcontroller, mit Einrichtungen zum Starten des Selbsttests und zu dessen interner Durchführung, wobei der Selbsttest alle wesentlichen Elemente des Microprozessors erfaßt, sowie zur Ausgabe einer entsprechenden Testantwort,
**dadurch gekennzeichnet**,
daß die Anordnung Einrichtungen zur Speicherung des Selbsttestprogramms sowieEinrichtungen zur Trennung der externen Ein- und Ausgabeeinrichtungen der Anordnung von den Einrichtungen (22) zur Durchführung des Selbsttests während der Dauer des Selbsttests aufweist.

15. Anordnung nach Anspruch 14,
**dadurch gekennzeichnet**,
daß der Microcontroller (10) mit einem Boundary Scan, insbesondere entsprechend IEEE-Standard 1149.1, ausgestattet ist, wobei nur die obligatorischen Testbefehle für den Fertigungstest implementiert sind und daß das Testprogramm im Microcontroller (10) selbst gespeichert ist.

16. Anordnung nach Anspruch 14 oder 15,
**dadurch gekennzeichnet**,
daß das im Microcontroller (10) gespeicherte Testprogramm ein standardisierter Selbsttest (BIST, Built-In Self Test) ist.

17. Anordnung nach Anspruch 15 oder 16,
**dadurch gekennzeichnet**,
daß eine Boundary Scan-Zelle (26) der Anordnung mit Schaltelementen XOR (32, 42) und Multiplexer (34, 36) ausgestattet ist und daß mittels eines Signals LFSR (Linear Feedback Shift Register) (30) während des Selbsttests das Boundary Scan-Schieberegister aufgetrennt wird und über das LFSR-Testmuster generiert werden.

18. Anordnung nach Anspruch 17,
**dadurch gekennzeichnet**,
daß mit jedem Takt des Signals CLOCKDR ein neues Testmuster erzeugt wird.

19. Anordnung nach Anspruch 17 oder 18,
**dadurch gekennzeichnet**,
daß mittels des Signals MISR (Multiple Input Signatur Register) (40) während des Selbsttests das Boundary Scan-Schieberegister aufgetrennt wird und das MISR (40) die Testantworten aus dem Schaltungskern aufsummiert.

20. Anordnung nach Anspruch 19,
**dadurch gekennzeichnet**,
daß mit jedem Takt des Signals CLOCKDR eine weitere Testantwort aufsummiert wird.

21. Anordnung nach Anspruch 20,
**dadurch gekennzeichnet**,
daß der BIST-Controller (22) die Register des Boundary Scan nützt, um Chip-intern die Testantworten zu komprimieren.

22. Anordnung einem oder mehreren der Ansprüche 16 bis 21,
**dadurch gekennzeichnet**,
daß der BIST über den Microcontroller (10) gestartet wird.

23. Anordnung nach einem oder mehreren der vorhergehenden Ansprüche 16 bis 22,
**dadurch gekennzeichnet**,
daß vor dem Start des BIST die Berechtigung zur Durchführung des Selbsttests durch den Microcontroller (10) geprüft wird.

24. Anordnung nach einem oder mehreren der vorhergehenden Ansprüche,
**dadurch gekennzeichnet**,
daß die korrekte Ausführung des Selbsttests durch den Microcontroller (10) überwacht und insbesondere keine Unterbrechung des Selbsttests zugelassen wird.

25. Anordnung nach einem oder mehreren der Ansprüche 16 bis 24,
**dadurch gekennzeichnet**,
daß vom TAP-Controller (24) generierte interne Steuersignale (MODE_T, UPDATE_T, SHIFT_T, CLOCK_T) während des laufenden Selbsttests durch Signale (SHIFT_B, BIST) aus dem BIST-Controller (22) blockiert werden, wodurch der TAP-Controller (24) logisch von den Boundary Scan-Zellen (26) getrennt wird.

26. Anordnung nach Anspruch 25,
**dadurch gekennzeichnet**,
daß der BIST-Controller (22) während des Selbsttests über SYS_CLK, dem Systemtakt des Microcontrollers (10), getaktet wird.

27. Anordnung nach Anspruch 26,
**dadurch gekennzeichnet**,
daß die angesteuerten Multiplexer (34, 44) so eingestellt werden, daß über die Eingangspins keine externen Daten in den Schaltungskern und keine (Zwischen-) Testantworten an die Ausgangspins des Microcontrollers (10) gelangen.

28. Anordnung nach Anspruch 27,
**dadurch gekennzeichnet**,
daß während des Selbsttests keine (Zwischen-) Testantworten an die Ausgangspins des Microcontrollers (10) gelangen.

29. Anordnung nach Anspruch 28,
**dadurch gekennzeichnet**,
daß das Signal SHIFTDR für die LFSR zur Bildung der Schiebefunktion auf '1'-Pegel gesetzt wird.

30. Anordnung nach Anspruch 29,
**dadurch gekennzeichnet**,
daß während des Selbsttests das Signal CLOCKDR, mit dem LFSR (30) und MISR (40) getaktet werden, auf SYS-CLK, dem Systemtakt des Microcontrollers (10), umgestellt wird.

31. Anordnung nach Anspruch 30,
**dadurch gekennzeichnet**,
daß aus dem Boundary Scan-Schieberegister keine (Zwischen-) Testantworten an den externen Ausgang TDO des TAP-Controllers (24) gelangen.

32. Anordnung nach einem oder mehreren der vorhergehenden Ansprüche,
**dadurch gekennzeichnet**,
daß, nachdem der im IEEE-Standard 1149.1 angegebene TAP-Controller (24) logisch von den Boundary Scan-Zellen (26) abgekoppelt wurde, die Testlogik in einen definierten Anfangszustand gesetzt wird.

33. Microcontroller, versehen mit Einrichtungen zur Durchführung des Verfahrens gemäß einem der Ansprüche 1 bis 13, insbesondere in Form einer Anordnung gemäß einem der Ansprüche 14 bis 32.
